# EUROPEAN PATENT SPECIFICATION

(11) **EP 3 428 775 B1**
(45) Date of publication and mention of the grant of the patent: **16.09.2020**
(21) Application number: 16897769.2
(22) Date of filing: 07.12.2016
(51) Int. Cl.: G06F 1/3293, G06F 1/3296, G06F 9/4401

(54) **METHOD AND TERMINAL FOR DETERMINING TERMINAL PROCESSOR VOLTAGE**
VERFAHREN UND ENDGERÄT ZUR BESTIMMUNG DER KLEMMENPROZESSORSPANNUNG
PROCÉDÉ ET TERMINAL PERMETTANT DE DÉTERMINER UNE TENSION DE PROCESSEUR DE TERMINAL

(30) Priority: 06.04.2016 CN 201610210836
(43) Date of publication of application: 16.01.2019
(73) Proprietor: Huawei Technologies Co., Ltd., Longgang District Shenzhen, Guangdong 518129 (CN)
(72) Inventor: TSAO, Youming, Shenzhen Guangdong 518129 (CN); YU, Jianfeng, Shenzhen Guangdong 518129 (CN); YAO, Cong, Shenzhen Guangdong 518129 (CN)
(74) Representative: Goddar, Heinz J.
(86) International application number: PCT/CN2016/108852
(87) International publication number: WO 2017/173840

(56) References cited:
- WO-A1-2008/121113
- CN-A- 101 894 036
- CN-A- 102 033 594
- CN-A- 102 122 202
- CN-A- 103 049 064
- CN-A- 104 951 029
- CN-A- 104 951 029
- JP-A- 2005 141 623
- US-A1- 2004 025 069
- US-A1- 2015 301 914

## Description

### TECHNICAL FIELD

This application relates to the communications field, and in particular, to a method for determining a voltage of a processor of a terminal, and a terminal.

### BACKGROUND

In a terminal powered by a battery, system power consumption is a very important problem. During running, power consumption of a central processing unit (CPU) accounts for a main part of system power consumption. Therefore, when a running speed of the CPU is ensured, usually the CPU is set to work at a minimum voltage, to reduce the system power consumption.

Currently, there are usually two methods for measuring a minimum working voltage of a CPU in a terminal. In one method, a machine, for example, automatic test equipment (Automatic Test Equipment, ATE) for mass production of CPUs is used to measure hundreds of different CPUs for statistical analysis and calibration. Specifically, different CPUs may be classified by using data of a statistical model. For example, the CPUs may be classified into a relatively fast low-voltage category and a relatively slow high-voltage category, that is, a category of a relatively fast running speed and a relatively low working voltage and a category of a relatively slow running speed and a relatively high working voltage. A statistical value of a minimum working voltage is measured for each category of CPUs. Because of differences between the different CPUs, the statistical model has a relatively great error, and a margin needs to be added in advance to ensure stable mass production. In addition, because a running environment in the machine for mass production of CPUs is different from a running environment in a terminal to which a CPU is actually applied, and during calibration, a statistical model of a large quantity of samples is used, an error may be generated in the calibration process. Consequently, an extra margin needs to be added again, to ensure more stable mass production. Further, an aging phenomenon occurs in a CPU, but an aging status cannot be reflected in the machine. Therefore, when CPUs are produced by using this method, a margin for aging further needs to be added in advance, to ensure that after a mass-produced CPU is used in a terminal for a period of time, the CPU can still maintain good performance.

In the other method, a machine for mass production of CPUs, for example, ATE, is used to test and calibrate each CPU, to determine a minimum working voltage of each CPU. Compared with the first method, although this method reduces an error of a CPU statistical model, an error caused by calibration and aging still cannot be resolved. In addition, because each CPU needs to be tested in the mass production machine to determine a minimum working voltage, in this method, a testing time and testing costs of the mass production machine are greatly increased.

Prior art document US 2015/0301914 A1 discloses a device wherein the power budget during the switch-on process is limited. Prior art document CN 104951029 discloses a device wherein a self test is performed, during the switch-on process, to determine the minimum operating voltage of a CPU.

### SUMMARY

This application provides a method for determining a voltage of a processor of a terminal, and a terminal, to more accurately measure a minimum working voltage of a processor.

According to a first aspect, a method for determining a voltage of a processor of a terminal is provided. The terminal includes an auxiliary processor and a CPU. The method includes: in a switch-on process of the terminal, after completing system initialization, determining, by the auxiliary processor, a minimum working voltage of the CPU; setting, by the auxiliary processor, a current voltage of the CPU to the minimum working voltage; and completing, by the CPU at the minimum working voltage, the switch-on process of the terminal, and controlling the terminal to work.

Therefore, in the method for determining a voltage of a processor of a terminal in this application, in the switch-on process of the terminal, the auxiliary processor determines the minimum working voltage of the CPU, and can enable the terminal to be switched on and work normally. Compared with that a testing machine measures a minimum working voltage of a processor during production of the processor, a testing time and testing costs can be reduced, testing precision can be improved, and a minimum working voltage of a processor can be more accurately tested. In addition, an error of a calibration margin when testing is performed on the machine and an error caused by aging of the processor can be overcome.

Optionally, the CPU may work at multiple frequencies, and then, when measuring the minimum working voltage of the CPU, the auxiliary processor may measure a minimum working voltage corresponding to each working frequency. For example, there are four working frequencies of the CPU: 1 GHz, 1.5 GHz, 2 GHz, and 2.5 GHz. Then, minimum working voltages corresponding to the working frequencies of 1 GHz, 1.5 GHz, 2 GHz, and 2.5 GHz are separately measured, so that a corresponding minimum working voltage is set according to a working frequency when the CPU works.

Optionally, because a temperature of a running environment of the CPU may change, a temperature of a current running environment may be recorded when the minimum working voltage of the CPU is measured, so that a temperature compensation is made for the minimum working voltage when a temperature of the CPU changes.

With reference to the first aspect, in an implementation of the first aspect, the determining a minimum working voltage of the CPU includes: determining, by the auxiliary processor, an initial working voltage *V*₀ at which the CPU can work normally; decreasing, by the auxiliary processor, a current voltage of the CPU from *V*_{*i*-1} to *Vᵢ*, where a value of i is successively 1, 2, 3, ...; and when the auxiliary processor determines that the CPU can work normally at the voltage of *Vᵢ*, decreasing, by the auxiliary processor, the current voltage of the CPU from *Vᵢ* to *V*_{*i*+1}; or when the auxiliary processor determines that the CPU cannot work normally at the voltage of *Vᵢ*, determining, by the auxiliary processor, that the minimum working voltage of the CPU is *V*_{*i*-1}.

It should be understood that for the first testing of a working voltage of the CPU, that is, no testing has been previously performed on the minimum working voltage of the CPU, the auxiliary processor determines the initial working voltage *V*₀ of the CPU, and the initial working voltage may be obtained by a process monitor (process monitor). The process monitor is configured to mark a running speed of the CPU, and determine, according to a correspondence between the running speed and the working voltage, that a working voltage corresponding to the running speed is the initial working voltage of the CPU.

It should be understood that for non-first testing of a working voltage of the CPU, that is, testing of a minimum working voltage has been previously performed when the CPU is switched on, when testing of a minimum working voltage is performed again after the CPU is switched on, the auxiliary processor may determine the current initial working voltage of the CPU by using a voltage value that is saved when the minimum working voltage is measured last time.

Optionally, the auxiliary processor may save, in a storage unit, a working voltage that is obtained after each voltage testing during each switch-on, and the CPU may save, in the storage unit, a testing result eigenvalue corresponding to each working voltage, so that the auxiliary processor obtains the testing result eigenvalue for comparison.

With reference to the first aspect and the foregoing implementation, in another implementation of the first aspect, the determining a minimum working voltage of the CPU includes: determining, by the auxiliary processor, an initial working voltage *V*₀ at which the CPU cannot work normally; increasing, by the auxiliary processor, the current voltage of the CPU from *V*_{*i*-1} to *Vᵢ*, where a value of i is successively 1, 2, 3, ...; and when the auxiliary processor determines that the CPU cannot work normally at the voltage of *Vᵢ*, increasing, by the auxiliary processor, the current voltage of the CPU from *Vᵢ* to *V*_{*i*+1}; or when the auxiliary processor determines that the CPU can work normally at the voltage of *Vᵢ*, determining, by the auxiliary processor, that the minimum working voltage of the CPU is *Vᵢ*.

It should be understood that if the auxiliary processor determines the initial working voltage of the CPU, and the initial working voltage cannot enable the CPU to work normally, that is, the initial working voltage is lower than the minimum working voltage of the CPU, the minimum working voltage may be obtained by increasing the voltage.

It should be understood that the working voltage of the CPU is decreased from the initial working voltage *V*₀ to *V*₁, and then, is decreased from *V*_{*i*-1} to *Vᵢ*, where a value of i is successively 1, 2, 3, .... Alternatively, the working voltage of the CPU is increased from the initial working voltage *V*₀ to *V*₁, and then, is increased from *V*_{*i*-1} to *Vᵢ*, where a value of i is successively 1, 2, 3, .... A difference between any two consecutive working voltages *V*_{*i*-1} and *Vᵢ* may be set according to an actual situation, and differences may be the same or may be different.

It should be understood that the setting of a difference between tested voltages may affect accuracy of testing a minimum working voltage. A voltage generating a relatively small difference is selected for measurement, so that a more accurate minimum working voltage can be obtained.

With reference to the first aspect and the foregoing implementations, in another implementation of the first aspect, the determining a minimum working voltage of the CPU includes: determining, by the auxiliary processor, a working voltage domain (*V*₀, *V*₁) of the CPU, where the CPU cannot work normally at the voltage of *V*₀, and can work normally at the voltage of *V*₁; determining, by the auxiliary processor, m voltage values within the working voltage domain (*V*₀, *V*₁), and performing voltage measurement for the CPU for m times; determining, by the auxiliary processor, n voltage values within the working voltage domain (*V*₀, *V*₁) according to the m times of voltage measurement, where the CPU can work normally at each of the n voltage values, and n is less than or equal to m; and determining, by the auxiliary processor, a smallest voltage value in the n voltage values as the minimum working voltage of the CPU.

It should be understood that the auxiliary processor determines, within the working voltage domain (*V*₀, *V*₁), the m voltage values for voltage measurement. Optionally, any voltage value *V*₂ may be selected from (*V*₀, *V*₁). For example, *V*₂ is an average value of *V*₀ and *V*₁. The auxiliary processor sets the voltage of the CPU to *V*₂, and determines whether the CPU can work normally at the voltage of *V*₂. If the CPU can work normally at the voltage of *V*₂, the auxiliary processor can determine that the minimum working voltage of the CPU is located within the range of (*V*₀, *V*₁). If the CPU cannot work normally at the voltage of *V*₂, the auxiliary processor can determine that the minimum working voltage of the CPU is located within a range of (*V*₂, *V*₁). The auxiliary processor continues to determine, within the new determined range, a new voltage value for measurement. A range of the minimum working voltage of the CPU is constantly narrowed until it is determined after m times of measurement that the minimum working voltage of the CPU is located within a range of (*Vᵢ, Vⱼ*). Then, it is determined that the minimum working voltage of the CPU is *Vⱼ*.

It should be understood that, in the foregoing method, there may be n voltage values during m times of measurement, where n is less than or equal to m, so that the CPU can work normally at each of the n voltage values, and the finally determined minimum working voltage *Vⱼ* of the CPU is a smallest value in the n voltage values. Therefore, the foregoing method may be extended. For example, any m voltage values within the working voltage domain (*V*₀, *V*₁) of the CPU are determined for separate measurement. Then, in a measurement process of the m voltage values, there may be n voltage values in the m voltage values, where each of the n voltage values can enable the CPU to work normally, and n is less than or equal to m. In this case, the auxiliary processor may determine that a smallest value in the n voltage values is the minimum working voltage of the CPU.

In this way, a quantity of times of testing is limited when the minimum working voltage of the CPU is determined, so that the range of the minimum working voltage of the CPU can be constantly narrowed, and a more accurate minimum working voltage can be determined.

With reference to the first aspect and the foregoing implementations, in another implementation of the first aspect, the method further includes: when the auxiliary processor has obtained, within a preset time, a testing result eigenvalue *Tᵢ* that is determined by the CPU at the voltage of *Vᵢ*, and *Tᵢ* is the same as a preset value, determining, by the auxiliary processor, that the CPU can work normally at the voltage of *Vᵢ*; when the auxiliary processor has obtained *Tᵢ* within the preset time, and *Tᵢ* is not the same as the preset value, determining, by the auxiliary processor, that the CPU cannot work normally at the voltage of *Vᵢ*; and when the auxiliary processor has not obtained *Tᵢ* within the preset time, determining, by the auxiliary processor, that the CPU cannot work normally at the voltage of *Tᵢ*.

In this way, the preset time is set. For example, a timer is set. It is determined according to the preset time whether the CPU can work normally, thereby improving the testing efficiency.

According to a second aspect, a terminal is provided, configured to perform the method in the first aspect or any possible implementation of the first aspect. Specifically, the terminal includes a CPU and an auxiliary processor. The auxiliary processor is configured to determine a minimum working voltage of the CPU. The auxiliary processor is further configured to set a current voltage of the CPU to the minimum working voltage. The CPU is configured to: complete, at the minimum working voltage, a switch-on process of the terminal, and control the terminal to work.

### BRIEF DESCRIPTION OF DRAWINGS

FIG. 1 is a schematic flowchart of a method for determining a voltage of a processor of a terminal according to an embodiment of this application;
FIG. 2 is a schematic diagram of a working mode and a testing mode of a processor in a terminal according to an embodiment of this application;
FIG. 3 is a schematic flowchart of a method for determining a voltage of a processor of a terminal according to an embodiment of this application; and
FIG. 4 is a schematic block diagram of a terminal according to an embodiment of this application.

### DESCRIPTION OF EMBODIMENTS

The following clearly and completely describes the technical solutions in the embodiments of this application with reference to the accompanying drawings in the embodiments of this application.

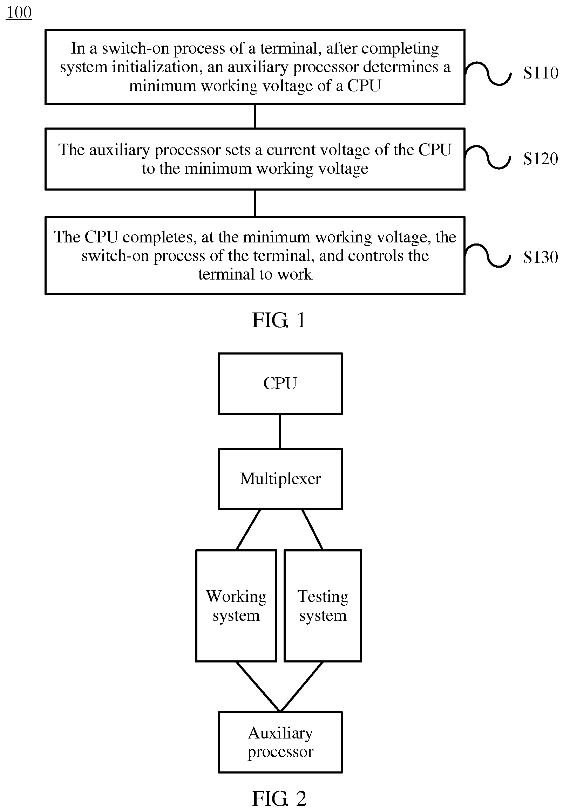

FIG. 1 is a schematic flowchart of a method 100 for determining a voltage of a processor of a terminal according to an embodiment of this application. The method 100 may be performed by a terminal. The terminal may be powered by a battery. For example, the terminal may be a smartphone, or a smart notebook computer. The terminal includes two processors: an auxiliary processor and a CPU. The method 100 specifically includes the following steps.

S110. In a switch-on process of the terminal, after completing system initialization, the auxiliary processor determines a minimum working voltage of the CPU.

It should be understood that, in the prior art, the terminal usually completes the switch-on process of the terminal by using only one CPU. In the switch-on process of the terminal, the CPU controls and performs the entire switch-on process of the terminal, and after the terminal is switched on, controls the terminal to work normally. In this embodiment of this application, the switch-on process of the terminal is completed by means of two processors. The two processors may be referred to as the CPU and the auxiliary processor. The two processors complete, in the switch-on process of the terminal, a process of measuring a minimum working voltage of the CPU. After the terminal is switched on, the CPU controls the terminal to work and run normally. Optionally, the auxiliary processor may be another CPU. That is, the terminal may include two CPUs.

Specifically, the switch-on process of the terminal may be divided into two parts according to a time order. One part is a system initialization process of the terminal, and the other part is a switch-on and running process of a system. The auxiliary processor is mainly used for the first part of the switch-on process of the terminal, that is, the system initialization process. After the system initialization is completed, the auxiliary processor measures a minimum voltage of the CPU. The system initialization process is similar to that in the prior art, and may include a power-on process of each part of the terminal, and an initialization process of a memory. The memory may be a dynamic random access memory (Dynamic Random Access Memory, DRAM). After the auxiliary processor completes the system initialization, the CPU may enter a voltage testing mode, and the minimum working voltage of the CPU is measured.

Similar to a processor of an existing terminal, the CPU may be a multi-core processor. When a minimum working voltage of the target processor is measured, a minimum working voltage of each core in the multiple cores included in the CPU is measured, or the multiple cores are considered as an entirety, and the minimum working voltage of the CPU is measured and is used as a minimum working voltage of each core. Therefore, in this embodiment of this application, when the minimum working voltage of the CPU is measured, the CPU may be any core of the processor, or may refer to multiple cores of the processor. This is not limited in this embodiment of this application.

In this embodiment of this application, after completing the system initialization, the auxiliary processor measures the minimum working voltage of the CPU. Specifically, as shown in FIG. 2, the terminal may be divided into two parts. One part is a working system, and the other part is a testing system. Each system includes an apparatus or a module that can enable the CPU and the auxiliary processor to work normally or exchange information. The auxiliary processor may be connected to both the working system and the testing system, and the terminal may enable the CPU to switch between the working system and the testing system. For example, the terminal may include a multiplexer. When the CPU enters a minimum working voltage testing mode, the multiplexer connects the CPU to the testing system, and disconnects the CPU from the working system. When measurement of the minimum working voltage of the CPU is completed, and the CPU enters a normal working mode, the multiplexer connects the CPU to the working system, and disconnects the CPU from the testing system. In this way, during measurement of the minimum working voltage of the CPU, if an error occurs on the CPU, running of other functions of the terminal may not be affected, thereby ensuring that normal working of the terminal and measurement of the minimum working voltage do not affect each other. For example, when the CPU is in a testing mode, the CPU is connected only to the testing system. That is, the CPU can exchange information related to the testing process with the auxiliary processor only by using the testing system. Therefore, when an error occurs in the testing process of the CPU, running of the working system is not affected, and normal working of a part that is of the auxiliary processor and connected to the working system is not affected either. In addition, the auxiliary processor may be connected to the working system or the testing system, or may read a storage unit in the working system or the testing system. For example, the auxiliary processor reads a storage unit in the testing system, and may determine the minimum working voltage of the CPU, or the auxiliary processor is connected to the working system, and may perform the system initialization process during switch-on of the terminal.

Optionally, the working system may include a storage unit. The storage unit may be a static random access memory (Static Random Access Memory, DRAM), or may be a flash memory (Flash EEPROM Memory). The working system may further include a peripheral system (Peripheral System). The peripheral system includes another component that enables the system of the terminal to work normally, other than the storage unit, for example, an I2C (Inter-Integrated Circuit) bus, or a clock source (Clock source).

Optionally, the testing system includes a storage unit. The storage unit may be a DRAM, or may be a flash memory. The testing system may further include other components, for example, a counter, configured to record a quantity of times of testing during voltage testing of the CPU, and a system interruption controller, configured for information exchange between the CPU and another processor such as the auxiliary processor.

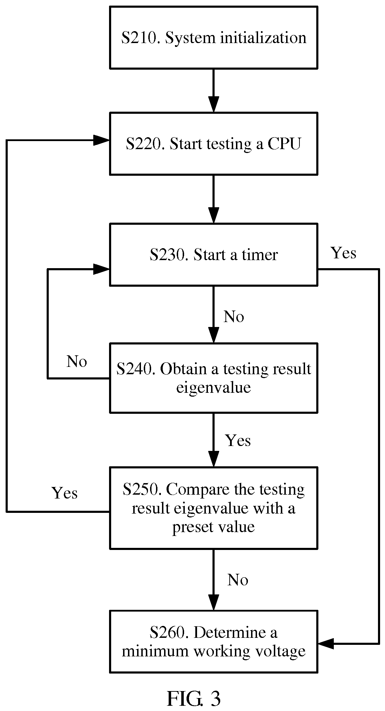

Specifically, the auxiliary processor may determine the minimum working voltage of the CPU in multiple manners. For example, as shown in FIG. 3, FIG. 3 shows a method 200 for determining a minimum working voltage of a target processor according to an embodiment of this application. Herein, a description is provided first by using an example in which a minimum working voltage is determined by decreasing a voltage.

S210. The auxiliary processor completes system initialization in the switch-on process of the terminal.

In this way, the CPU may enter a voltage testing mode, and the auxiliary processor may start testing the minimum working voltage of the CPU.

S220. The auxiliary processor sets a voltage for the CPU when testing starts.

Specifically, for the first round of voltage testing during current switch-on, the auxiliary processor first determines an initial working voltage *V*₀ of the CPU.

Specifically, it may be determined first whether measurement of a minimum working voltage is performed for the CPU for the first time. When it is determined that the measurement of a minimum working voltage is performed for the CPU for the first time, for example, measurement of a minimum working voltage is performed for the CPU in the terminal for the first time in the first switch-on process of the terminal, the CPU may obtain the initial working voltage by using a process monitor (process monitor). The process monitor may be configured to mark a running speed of the CPU, and by using a correspondence between the running speed and a working voltage, for example, by looking up a mapping table between the running speed and a working voltage, determine that a working voltage corresponding to the running speed is the initial working voltage of the CPU.

When it is determined that measurement of a minimum working voltage has been previously performed for the CPU, a tested voltage value saved during previous measurement of a minimum working voltage of the CPU may be obtained by reading the storage unit, and the initial working voltage is set according to the tested voltage value. The storage unit may be configured to store a tested voltage value saved during measurement of a minimum working voltage of the CPU. The tested voltage value may include a minimum working voltage obtained by means of measurement during each switch-on of the CPU, or may include a voltage value that is set each time a minimum working voltage is measured. Optionally, the storage unit may be a DRAM, or may be a register (Register). In this embodiment of this application, after the CPU enters the testing mode, first, the initial working voltage is set for the CPU. The initial working voltage can enable the CPU to work normally. Optionally, if the CPU cannot work normally at the initial working voltage, the working voltage of the CPU may be increased, so that the increased working voltage can enable the CPU to work normally. Further, the increased working voltage is regarded as the initial working voltage, so that the initial working voltage can enable the CPU to work normally.

Optionally, for the other voltage testing after the first round of voltage testing during the current switch-on, the auxiliary processor may update the current voltage of the CPU according to each determined voltage value, so that the CPU enters a new round of voltage testing.

S230. The auxiliary processor starts a timer when a target processor enters current voltage testing.

Specifically, when the auxiliary processor determines a current working voltage for the target processor, and starts to perform the current voltage testing, the auxiliary processor starts the timer for timing, so that the auxiliary processor can determine whether running of the CPU at the current voltage is completed, or whether an error occurs on the CPU at the current voltage.

Optionally, in an embodiment, the timer may be set in the terminal, and it is determined by using the timer whether the CPU can work normally. Specifically, after the CPU enters the voltage testing mode, for any measurement process, for example, it is measured whether the CPU can work normally at the working voltage of *Vᵢ*, when the working voltage of the CPU is set to *Vᵢ*, the auxiliary processor may start the timer. When the timer does not expire, the auxiliary processor may continue to perform S240, and when the timer expires, the auxiliary processor performs S260.

Optionally, a time of the timer may be set according to a time application. For example, the time that is set for the timer needs to be greater than a time within which the CPU runs a complete process in a normal case, and determines a testing result eigenvalue, so that the auxiliary processor can determine, by using the timer, whether the CPU works normally.

S240. The CPU runs at a currently specified working voltage *Vᵢ*, and determines a testing result eigenvalue *Tᵢ*, and the auxiliary processor obtains the testing result eigenvalue *Tᵢ.*

In this embodiment of this application, it may be determined, by using the testing result eigenvalue, whether the CPU can work normally at the current voltage. Specifically, the CPU may run any program, and the CPU may determine a testing result eigenvalue obtained after the running. For example, for any voltage testing, the voltage of the CPU is *Vᵢ*. Correspondingly, the CPU determines the testing result eigenvalue *Tᵢ* obtained after the running, and saves the testing result eigenvalue *Tᵢ* into a storage unit of the testing system, so that the auxiliary processor obtains the testing result eigenvalue, and continues to perform S250. Optionally, if the auxiliary processor reads the storage unit, but does not obtain the testing result eigenvalue *Tᵢ* generated at the voltage of *Vᵢ*, the auxiliary processor may return to S230, and determines whether the timer expires. When the timer expires, if the auxiliary processor has not obtained the testing result eigenvalue *Tᵢ* generated at the current voltage of *Vᵢ*, the auxiliary processor may perform S260.

S250. The auxiliary processor compares the obtained testing result eigenvalue with a preset value.

Specifically, for any voltage testing, the auxiliary processor obtains the testing result eigenvalue *Tᵢ* obtained when the current voltage of the CPU is *Vᵢ*, and compares the testing result eigenvalue *Tᵢ* with the preset value. When the obtained testing result eigenvalue *Tᵢ* is the same as the preset value, it indicates that the CPU can work normally at the voltage, and the auxiliary processor decreases the voltage from *Vᵢ* to *V*_{*i*+1}, that is, updates the current voltage of the CPU to *V*_{*i*+1}, and continues to perform S220, that is, performs a new round of voltage testing until it is determined that the CPU cannot work normally. If the obtained testing result *Tᵢ* is not the same as the preset value, it indicates that the CPU cannot work normally at the voltage, and S260 is performed, that is, the minimum working voltage of the CPU is determined.

S260. The auxiliary processor determines the minimum working voltage of the CPU.

After the timer expires, when the auxiliary processor has not obtained the testing result eigenvalue of the CPU at the current voltage, or the auxiliary processor obtains though comparison that the testing result eigenvalue of the CPU at the current voltage is not the same as the preset value, the auxiliary processor can determine that the CPU cannot work normally at the current voltage, and can determine a previous voltage value of the CPU as the minimum working voltage value. Specifically, if the current voltage of the CPU is set to *Vᵢ*, but the auxiliary processor has not obtained the testing result eigenvalue *Tᵢ* corresponding to *Vᵢ* when the timer expires, that is, the CPU has not determined the testing result eigenvalue *Tᵢ* within the time that is set for the timer, or the auxiliary processor has obtained the testing result eigenvalue *Tᵢ* corresponding to the voltage *Vᵢ*, but the testing result eigenvalue *Tᵢ* is not the same as the preset value, the auxiliary processor can determine that the CPU cannot work normally, and determines that the minimum working voltage of the CPU is *V*_{*i*-1}.

Optionally, in an embodiment, using the first voltage testing during current switch-on as an example, first, the initial working voltage is set for the CPU, and after it is determined that the CPU can work normally at the initial working voltage, the working voltage of the CPU is decreased from the initial working voltage value *V*₀ to *V*₁, and it is determined whether the CPU can work normally at the working voltage of *V*₁.

When the timer does not expire, the auxiliary processor obtains a testing result eigenvalue *T*₁ generated when the voltage of the CPU is *V*₁. If the auxiliary processor has obtained the testing result eigenvalue *T*₁, and learns by means of comparison that the testing result eigenvalue *T*₁ generated at the working voltage of *V*₁ is the same as the preset value, the auxiliary processor can determine that the CPU can work normally at the working voltage of *V*₁, continues to decrease the working voltage from *V*₁ to *V*₂, and continues to determine whether the CPU can work normally at the working voltage. When the auxiliary processor learns by means of comparison that the testing result eigenvalue *Tᵢ* generated at the working voltage of *Vᵢ* is not the same as the preset value, the auxiliary processor can determine that the CPU cannot work normally at the working voltage of *Vᵢ*, and determine that the minimum working voltage of the CPU is *V*_{*i*-1}.

When the timer expires, if the auxiliary processor has not obtained the testing result eigenvalue *T*₁ generated when the voltage of the CPU is *V*₁, that is, the CPU has not determined the testing result eigenvalue *T*₁ within the preset time of the timer, the auxiliary processor determines that the CPU cannot work normally at the voltage of *V*₁, and determine that the minimum working voltage of the CPU is *V*₀. Similarly, when the CPU can work normally at the voltage of *V*₁, the auxiliary processor continues to decrease the voltage for testing. For any testing thereafter, the voltage *Vᵢ* is set for the CPU. When the timer expires, if the auxiliary processor has not obtained the testing result eigenvalue *Tᵢ* generated at the voltage of *Vᵢ*, the auxiliary processor can determine that the CPU cannot work normally, and determine that the minimum working voltage of the CPU is *V*_{*i*-1}.

It should be understood that, in this embodiment, under the premise that the initial working voltage can enable the CPU to work normally, the tested voltage is decreased to determine the minimum working voltage. That is, the initial working voltage is greater than the minimum working voltage. Similarly, the premise may be set to that the initial working voltage cannot enable the CPU to work normally, the tested voltage is increased to determine the minimum working voltage. That is, the initial working voltage is less than the minimum working voltage.

Specifically, the initial working voltage *V*₀ is set to a relatively low value, so that the CPU cannot work normally at the voltage, and the voltage value is increased to *V*₁. When it is determined according to the foregoing method, that the CPU still cannot work normally at the voltage of *V*₁, the voltage value continues to be increased to *V*₂, until the voltage value is increased to *Vᵢ*, and the CPU can work normally. In this case, the minimum working voltage of the CPU is *Vᵢ*.

It should be understood that the working voltage of the CPU is decreased from the initial working voltage *V*₀ to *V*₁, and then, is decreased from *V*_{*i*-1} to *Vᵢ*, where a value of i is successively 1, 2, 3, .... Alternatively, the working voltage of the CPU is increased from the initial working voltage *V*₀ to *V*₁, and then, is increased from *V*_{*i*-1} to *Vᵢ*, where a value of i is successively 1, 2, 3, .... A difference between any two consecutive working voltages *V*_{*i*-1} and *Vᵢ* may be set according to an actual situation, and differences may be the same or may be different. Specifically, if it is considered to ensure accuracy of measuring the minimum working voltage of the CPU, a difference between *V*_{*i*-1} and *Vᵢ* may be set to a relatively small value. However, this may increase a quantity of times of testing, leading to relatively long duration of the testing process. If duration of the testing process or a testing speed is considered, a difference between *V*_{*i*-1} and *Vᵢ* may be set to a relatively large value. However, this may affect testing precision, and an error is caused to the minimum working voltage value obtained by means of testing. Therefore, the testing precision and the testing efficiency may be considered to select an appropriate voltage difference.

Optionally, in an embodiment, voltage measurement may be performed in both a voltage increasing manner and a voltage decreasing manner. Specifically, the auxiliary processor determines a working voltage domain (*V*₀, *V*₁) of the CPU. The CPU cannot work normally at the voltage of *V*₀, and can work normally at the voltage of *V*₁. That is, the working voltage domain (*V*₀, *V*₁) includes the minimum working voltage value of the CPU. The auxiliary processor may determine the minimum working voltage of the CPU by means of multiple measurements. For example, the auxiliary processor may first determine any voltage value *V*₂ within the working voltage domain (*V*₀, *V*₁). For example, *V*₂ is an average value of *V*₀ and *V*₁. The auxiliary processor sets the voltage of the CPU to *V*₂, and determines, according to a determining process similar to that in FIG. 3, whether the CPU can work normally at the voltage of *V*₂. If the CPU can work normally at the voltage of *V*₂, the auxiliary processor can determine that the minimum working voltage of the CPU is located within (*V*₀, *V*₂). If the CPU cannot work normally at the voltage of *V*₂, the auxiliary processor can determine that the minimum working voltage of the CPU is located within (*V*₂, *V*₁). The auxiliary processor continues to determine, within the new determined range, a new voltage value for measurement. A range of the minimum working voltage of the CPU is constantly narrowed until it is determined after a preset quantity of times of measurement, for example, m times of measurement, that the minimum working voltage of the CPU is located within a range of (*Vᵢ*, *Vⱼ*). Then, it is determined that the minimum working voltage of the CPU is *Vⱼ*.

There may be n voltage values during m times of measurement, where n is less than or equal to m, so that the CPU can work normally at each of the n voltage values, and the finally determined minimum working voltage *Vⱼ* of the CPU is a smallest value in the n voltage values. Therefore, the foregoing method may be further extended as: The auxiliary processor determines, within the working voltage domain (*V*₀, *V*₁) of the CPU, any m voltage values for measurement. The CPU cannot work normally at the voltage of *V*₀, and can work normally at the voltage of *V*₁. That is, the working voltage domain (*V*₀, *V*₁) includes the minimum working voltage value of the CPU. Then, in a measurement process of the m voltage values, there may be n voltage values in the m voltage values, where each of the n voltage values can enable the CPU to work normally, and n is less than or equal to m. In this case, the auxiliary processor may determine that a smallest value in the n voltage values is the minimum working voltage of the CPU.

It should be understood that a quantity m of times of measurement that is performed by the auxiliary processor for the CPU may be set according to an actual situation. For example, if measurement accuracy is considered, a value of m may be set to a relatively large value. However, in this way, a quantity of times of testing is excessively large, affecting testing duration and affecting a switch-on time of the terminal. If the switch-on time is considered, a value of m may be set to a relatively small value. However, this may affect testing precision. Therefore, multiple factors may be considered to set the quantity m of times of measurement.

In this embodiment of this application, the CPU may work at multiple working frequencies. Therefore, the measuring a minimum working voltage of the CPU includes: measuring a minimum working voltage of the CPU in a corresponding working frequency. For example, the working frequencies of the CPU include 1 GHz, 1.5 GHz, 2 GHz, and 2.5 GHz, and minimum working voltages of the CPU in the working frequencies of 1 GHz, 1.5 GHz, 2 GHz, and 2.5 GHz are separately measured, so that when the CPU works, a corresponding minimum working voltage is set according to a working frequency. For example, when the working frequency of the CPU is 1 GHz, the working voltage of the CPU is set to the minimum working voltage corresponding to the working frequency of 1 GHz.

In this embodiment of this application, the CPU may further include a temperature sensor (temperature sensor). The temperature sensor measures a temperature of a working environment of the CPU. After determining the minimum working voltage of the CPU, the auxiliary processor may record the temperature of the working environment of the CPU at the same time, and obtain a minimum working voltage in this temperature, so that when the temperature of the working environment of the CPU changes, the auxiliary processor makes temperature compensation for the working voltage. In this way, it can be ensured that when the CPU works at the minimum working voltage, even if the temperature changes, temperature compensation can still be made to ensure that the CPU works normally.

In this embodiment of this application, the CPU may further include a voltage sensor (voltage sensor). When the system runs, it may be determined by using the voltage sensor whether a voltage sag occurs. When a level of the voltage sag is relatively large, a frequency of the CPU may be decreased, avoiding system abnormality of the CPU caused by an excessively high level of voltage sag.

S120. The auxiliary processor sets a current voltage of the CPU to the minimum working voltage.

S130. The CPU completes, at the minimum working voltage, the switch-on process of the terminal, and controls the terminal to work.

In this embodiment of this application, after the minimum working voltage of the CPU is determined, that is, testing for the CPU is completed, the CPU may enter the normal working mode by means of the working system. The CPU is enabled to work at the minimum working voltage, so that the CPU continues to complete a second part of the switch-on process of the terminal, to complete the switch-on and running process of the system, for example, complete starting of an operating system of the terminal. Therefore, the switch-on process of the terminal is completed, the terminal enters the normal working mode, and the CPU continues to control the terminal to run normally. Optionally, after the CPU enters the normal working mode, the auxiliary processor transfers a right of controlling the terminal to the CPU. The CPU controls the terminal to run. At the same time, the auxiliary processor may assist the terminal in performing another work, so that the terminal runs normally. Alternatively, the auxiliary processor does not perform another work. This embodiment of this application is not limited thereto.

It should be understood that, in the embodiments of this application, sequence numbers of the processes do not represent an execution sequence. The execution sequence of the processes should be determined according to the functions and internal logic. The sequence numbers should not constitute any limitation on the implementation processes of the embodiments of this application.

Therefore, in the method for determining a voltage of a processor of a terminal in this embodiment of this application, in the switch-on process of the terminal, the auxiliary processor completes system initialization, measures the minimum working voltage of the CPU, and completes the final switch-on and running process of the terminal by using the CPU working at the minimum working voltage, so that the terminal is switched on and works normally. Compared with that a minimum working voltage of a processor is measured by using a testing machine during production of the processor, in the present invention, a testing time and testing costs can be reduced, testing precision can be improved, and a minimum working voltage of a processor can be more accurately tested. In addition, an error of a calibration margin when testing is performed on the machine and an error caused by aging of the processor can be overcome.

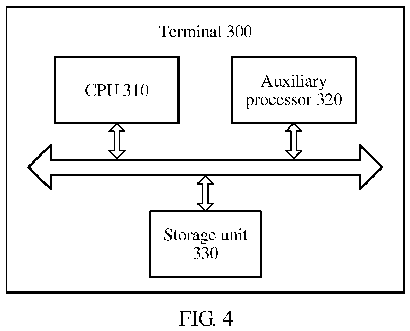

The foregoing has described in detail, with reference to FIG. 1 to FIG. 3, the method for determining a voltage of a processor of a terminal in the embodiments of this application. The following describes, with reference to FIG. 4, the terminal in the embodiments of this application.

As shown in FIG. 4, a terminal 300 according to an embodiment of this application includes a CPU 310 and an auxiliary processor 320. Specifically:

The auxiliary processor 320 is configured to: in a switch-on process of the terminal, after completing system initialization, determine a minimum working voltage of the CPU 310.

The auxiliary processor 320 is further configured to set a current voltage of the CPU 320 to the minimum working voltage.

The CPU 310 is configured to: complete, at the minimum working voltage, the switch-on process of the terminal, and control the terminal to work.

Therefore, in the terminal in this embodiment of this application, in the switch-on process of the terminal, the auxiliary processor completes system initialization, measures the minimum working voltage of the CPU, and completes the final switch-on and running process of the terminal by using the CPU working at the minimum working voltage, so that the terminal is switched on and works normally. Compared with that a minimum working voltage of a processor is measured by using a testing machine during production of the processor, in the present invention, a testing time and testing costs can be reduced, testing precision can be improved, and a minimum working voltage of a processor can be more accurately tested. In addition, an error of a calibration margin when testing is performed on the machine and an error caused by aging of the processor can be overcome.

Optionally, the auxiliary processor 320 is specifically configured to: determine an initial working voltage *V*₀ at which the CPU 310 can work normally; decrease the current voltage of the CPU 310 from *V*_{*i*-1} to *Vᵢ*, where a value of i is successively 1, 2, 3, ...; and when determining that the CPU 310 can work normally at the voltage of *Vᵢ*, decrease the current voltage of the CPU 310 from *Vᵢ* to *V*_{*i*+1} ; or when determining that the CPU 310 cannot work normally at the voltage of *Vᵢ*, determine that the minimum working voltage of the CPU 310 is *V*_{*i*-1}.

Optionally, the auxiliary processor 320 is specifically configured to: determine an initial working voltage *V*₀ at which the CPU 310 cannot work normally; increase the current voltage of the CPU 310 from *V*_{*i*-1} to *Vᵢ*, where a value of i is successively 1, 2, 3, ...; and when determining that the CPU 310 cannot work normally at the voltage of *Vᵢ*, increase the current voltage of the CPU 310 from *Vᵢ* to *V*_{*i*+1}; or when determining that the CPU 310 can work normally at the voltage of *Vᵢ*, determine that the minimum working voltage of the CPU 310 is *Vᵢ*.

Optionally, the auxiliary processor 320 is specifically configured to: determine a working voltage domain (*V*₀, *V*₁) of the CPU 310, where the CPU 310 cannot work normally at the voltage of *V*₀, and can work normally at the voltage of *V*₁; determine m voltage values within the working voltage domain (*V*₀, *V*₁), and perform voltage measurement for the CPU 310 for m times; determine n voltage values within the working voltage domain (*V*₀, *V*₁) according to the m times of voltage measurement, where the CPU 310 can work normally at each of the n voltage values, and n is less than or equal to m; and determine a smallest voltage value in the n voltage values as the minimum working voltage of the CPU 310.

Optionally, the auxiliary processor 320 is specifically configured to: when the auxiliary processor has obtained, within a preset time, a testing result eigenvalue *Tᵢ* that is determined by the CPU 310 at the voltage of *Vᵢ*, and *Tᵢ* is the same as a preset value, determine that the CPU 310 can work normally at the voltage of *Vᵢ*; when the auxiliary processor has obtained *Tᵢ* within the preset time, and *Tᵢ* is not the same as the preset value, determine that the CPU 310 cannot work normally at the voltage of *Vᵢ*; and when the auxiliary processor has not obtained *Tᵢ* within the preset time, determine that the CPU 310 cannot work normally at the voltage of *Vᵢ*.

Optionally, the terminal may further include a storage unit 330. The storage unit 330 is configured to store the current working voltage *Vᵢ* of the CPU 310 and a corresponding testing result eigenvalue *Tᵢ,* so that the auxiliary processor 320 obtains the working voltage *Vᵢ* and the testing result eigenvalue *Tᵢ*, and determines whether the CPU 310 can work normally.

It should be understood that, in this embodiment of this application, the auxiliary processor 320 may be a CPU, or the auxiliary processor 320 may be another general purpose processor, a digital signal processor (DSP), an application-specific integrated circuit (ASIC), a field programmable gate array (FPGA), or another programmable logic device, discrete gate or transistor logic device, discrete hardware component, or the like. The general purpose processor may be a microprocessor or the processor may be any conventional processor, or the like.

The storage unit 330 may include a read-only memory and a random access memory, and provide an instruction and data for the CPU 310 and the auxiliary processor 320. A part of the storage unit 330 may further include a non-volatile random access memory. For example, the storage unit 330 may further store information about a device type.

In an implementation process, steps in the foregoing methods can be implemented by using a hardware integrated logical circuit in the CPU 310 or the auxiliary processor 320, or by using instructions in a form of software. The steps of the methods disclosed with reference to the embodiments of this application may be directly performed by a hardware processor, or may be performed by using a combination of hardware in the processor and a software module. The software module may be located in a mature storage medium in the art, such as a random access memory, a flash memory, a read-only memory, a programmable read-only memory, an electrically erasable programmable memory, a register, or the like. The storage medium is located in the storage unit 330, and the CPU 310 or the auxiliary processor 320 may read information in the storage unit 330 and completes the steps in the foregoing methods in combination with hardware of the processor. To avoid repetition, details are not described herein again.

It should be understood that the terminal 300 according to this embodiment of this application may correspondingly perform the method 100 and the method 200 in the embodiments of this application, and the foregoing and other operations and/or functions of the components in the terminal 300 are separately used for implementing the corresponding process of the method in FIG. 1 to FIG. 3. For brevity, details are not described herein again.

Therefore, in the terminal in this embodiment of this application, in the switch-on process of the terminal, the auxiliary processor completes system initialization, measures the minimum working voltage of the CPU, and completes the final switch-on and running process of the terminal by using the CPU working at the minimum working voltage, so that the terminal is switched on and works normally. Compared with that a minimum working voltage of a processor is measured by using a testing machine during production of the processor, in the present invention, a testing time and testing costs can be reduced, testing precision can be improved, and a minimum working voltage of a processor can be more accurately tested. In addition, an error of a calibration margin when testing is performed on the machine and an error caused by aging of the processor can be overcome.

A person of ordinary skill in the art may be aware that, in combination with the examples described in the embodiments disclosed in this specification, method steps and units may be implemented by electronic hardware, computer software, or a combination thereof. To clearly describe the interchangeability between the hardware and the software, the foregoing has generally described steps and compositions of each embodiment according to functions. Whether the functions are performed by hardware or software depends on particular applications and design constraint conditions of the technical solutions. A person of ordinary skill in the art may use different methods to implement the described functions for each particular application, but it should not be considered that the implementation goes beyond the scope of this application.

Methods or steps described in the embodiments disclosed in this specification may be implemented by hardware, a software program executed by a processor, or a combination thereof. The software program may reside in a random access memory (RAM), a memory, a read-only memory (ROM), an electrically programmable ROM, an electrically erasable programmable ROM, a register, a hard disk, a removable disk, a CD-ROM, or any other form of storage medium known in the art.

This application is described in detail with reference to the accompanying drawings and in combination with the example embodiments, but this application is not limited thereto. The scope of protection of the present invention is defined by the appended claims. All the embodiments and examples in the above description which are not covered by the claims have been provided to fully understand the invention, however they are not part of it.

## Claims

1. A method for determining a voltage of a processor of a terminal (300), wherein the terminal comprises an auxiliary processor (320) and a central processing unit, CPU (310), and the method comprises:
in a switch-on process of the terminal, after completing system initialization, determining, by the auxiliary processor, a minimum working voltage of the CPU;
setting, by the auxiliary processor, a current voltage of the CPU to the minimum working voltage; and
completing, by the CPU at the minimum working voltage, the switch-on process of the terminal, and controlling the terminal to work.

2. The method according to claim 1, wherein the determining a minimum working voltage of the CPU (310) comprises:
determining, by the auxiliary processor (320), an initial working voltage *V*₀ at which the CPU can work normally;
decreasing, by the auxiliary processor, the current voltage of the CPU from *V*_{*i*-1} to *Vᵢ*, wherein a value of i is successively 1, 2, 3, ...; and
when the auxiliary processor determines that the CPU can work normally at the voltage of *vᵢ*, decreasing, by the auxiliary processor, the current voltage of the CPU from *Vᵢ* to *V*_{*i*+1}; or
when the auxiliary processor determines that the CPU cannot work normally at the voltage of *Vᵢ*, determining, by the auxiliary processor, that the minimum working voltage of the CPU is *V*_{*i*-1}.

3. The method according to claim 1, wherein the determining a minimum working voltage of the CPU (310) comprises:
determining, by the auxiliary processor (320), an initial working voltage *V*₀ at which the CPU cannot work normally;
increasing, by the auxiliary processor, the current voltage of the CPU from *V*_{*i*-1} to *Vᵢ*, wherein a value of i is successively 1, 2, 3, ...; and
when the auxiliary processor determines that the CPU cannot work normally at the voltage of *Vᵢ*, increasing, by the auxiliary processor, the current voltage of the CPU from *Vᵢ* to *V*_{*i*+1} ; or
when the auxiliary processor determines that the CPU can work normally at the voltage of *vᵢ*, determining, by the auxiliary processor, that the minimum working voltage of the CPU is *Vᵢ*.

4. The method according to claim 1, wherein the determining a minimum working voltage of the CPU (310) comprises:
determining, by the auxiliary processor (320), a working voltage domain (*V*₀, *V*₁) of the CPU, wherein the CPU cannot work normally at the voltage of *V*₀, and can work normally at the voltage of *V*₁;
determining, by the auxiliary processor, m voltage values within the working voltage domain (*V*₀, *V*₁), and performing voltage measurement for the CPU for m times;
determining, by the auxiliary processor, n voltage values within the working voltage domain (*V*₀, *V*₁) according to the m times of voltage measurement, wherein the CPU can work normally at each of the n voltage values, and n is less than or equal to m; and
determining, by the auxiliary processor, a smallest voltage value in the n voltage values as the minimum working voltage of the CPU.

5. The method according to claim 2 or 3, wherein the method further comprises:
when the auxiliary processor (320) has obtained, within a preset time, a testing result eigenvalue *Tᵢ* that is determined by the CPU (310) at the voltage of *Vᵢ*, and *Tᵢ* satisfies a preset value, determining, by the auxiliary processor, that the CPU can work normally at the voltage of *Vᵢ*;
when the auxiliary processor has obtained *Tᵢ* within the preset time, and *Tᵢ* doesn't satisfy the preset value, determining, by the auxiliary processor, that the CPU cannot work normally at the voltage of *Vᵢ*; and
when the auxiliary processor has not obtained *Tᵢ* within the preset time, determining, by the auxiliary processor, that the CPU cannot work normally at the voltage of *Vᵢ*.

6. A terminal (300), wherein the terminal comprises an auxiliary processor (320) and a central processing unit, CPU (310), wherein the auxiliary processor is configured to: in a switch-on process of the terminal, after completing system initialization, determine a minimum working voltage of the CPU;
the auxiliary processor is further configured to set a current voltage of the CPU to the minimum working voltage; and
the CPU is configured to: complete, at the minimum working voltage, the switch-on process of the terminal, and control the terminal to work.

7. The terminal (300) according to claim 6, wherein the auxiliary processor (320) is specifically configured to:
determine an initial working voltage *V*₀ at which the CPU (310) can work normally;
decrease the current voltage of the CPU from *V*_{*i*-1} to *Vᵢ*, wherein a value of i is successively 1, 2, 3, ...; and
when determining that the CPU can work normally at the voltage of *Vᵢ*, decrease the current voltage of the CPU from *Vᵢ* to *V*_{*i*+1} ; or
when determining that the CPU cannot work normally at the voltage of *Vᵢ*, determine that the minimum working voltage of the CPU is *V*_{*i*-1}.

8. The terminal (300) according to claim 6, wherein the auxiliary processor (320) is specifically configured to:
determine an initial working voltage *V*₀ at which the CPU (310) cannot work normally;
increase the current voltage of the CPU from *V*_{*i*-1} to *Vᵢ*, wherein a value of i is successively 1, 2, 3, ...; and
when determining that the CPU can work normally at the voltage of *Vᵢ*, increase the current voltage of the CPU from *Vᵢ* to *V*_{*i*+1} ; or
when determining that the CPU can work normally at the voltage of *Vᵢ*, determine that the minimum working voltage of the CPU is *Vᵢ.*

9. The terminal (300) according to claim 6, wherein the auxiliary processor (320) is specifically configured to:
determine a working voltage domain (*V*₀, *V*₁) of the CPU (310), wherein the CPU cannot work normally at the voltage of *V*₀, and can work normally at the voltage of *V*₁;
determine m voltage values within the working voltage domain (*V*₀, *V₁*), and perform voltage measurement for the CPU for m times;
determine n voltage values within the working voltage domain (*V*₀, *V*₁) according to the m times of voltage measurement, wherein the CPU can work normally at each of the n voltage values, and n is less than or equal to m; and
determine a smallest voltage value in the n voltage values as the minimum working voltage of the CPU.

10. The terminal (300) according to claim 7 or 8, wherein the auxiliary processor (320) is specifically configured to:
when the auxiliary processor has obtained, within a preset time, a testing result eigenvalue *Tᵢ* that is determined by the CPU (310) at the voltage of *Vᵢ*, and *Tᵢ* satisfis a preset value, determine that the CPU can work normally at the voltage of *Vᵢ*;
when the auxiliary processor has obtained *Tᵢ* within the preset time, and *Tᵢ* doesn't satisfy the preset value, determine that the CPU cannot work normally at the voltage of *Vᵢ*; and
when the auxiliary processor has not obtained *Tᵢ* within the preset time, determine that the CPU cannot work normally at the voltage of *Vᵢ*.

## Patentansprüche

1. Verfahren zum Bestimmen einer Spannung eines Prozessors eines Endgeräts (300), wobei das Endgerät einen Hilfsprozessor (320) und eine zentrale Verarbeitungseinheit (central processing unit - CPU) (310) umfasst und das Verfahren Folgendes umfasst:
in einem Einschaltprozess des Endgeräts, nach Abschließen der Systeminitialisierung, Bestimmen, durch den Hilfsprozessor, einer Mindestbetriebsspannung der CPU;
Einstellen, durch den Hilfsprozessor, einer Stromspannung der CPU auf die Mindestbetriebsspannung; und
Vervollständigen, durch die CPU bei der Mindestbetriebsspannung, des Einschaltprozesses des Endgeräts und Steuern des Endgeräts dazu, zu arbeiten.

2. Verfahren nach Anspruch 1, wobei das Bestimmen einer Mindestbetriebsspannung der CPU (310) Folgendes umfasst:
Bestimmen, durch den Hilfsprozessor (320), einer anfänglichen Betriebsspannung V₀, bei der die CPU normal arbeiten kann;
Verringern, durch den Hilfsprozessor, der Stromspannung der CPU von Vᵢ₋₁ auf Vᵢ, wobei der Wert von i aufeinanderfolgend 1, 2, 3, ... ist; und
wenn der Hilfsprozessor bestimmt, dass die CPU bei der Spannung von Vᵢ normal arbeiten kann, Verringern, durch den Hilfsprozessor, der Stromspannung der CPU von Vᵢ auf Vᵢ₊₁; oder
wenn der Hilfsprozessor bestimmt, dass die CPU bei der Spannung von Vᵢ nicht normal arbeiten kann, Bestimmen, durch den Hilfsprozessor, dass die Mindestbetriebsspannung der CPU Vᵢ₋₁ ist.

3. Verfahren nach Anspruch 1, wobei das Bestimmen einer Mindestbetriebsspannung der CPU (310) Folgendes umfasst:
Bestimmen, durch den Hilfsprozessor (310), einer anfänglichen Betriebsspannung V₀, bei der die CPU nicht normal arbeiten kann;
Erhöhen, durch den Hilfsprozessor, der Stromspannung der CPU von Vᵢ₋₁ auf Vᵢ, wobei ein Wert von i aufeinanderfolgend 1, 2, 3, ... ist; und
wenn der Hilfsprozessor bestimmt, dass die CPU bei der Spannung von Vᵢ nicht normal arbeiten kann, Erhöhen, durch den Hilfsprozessor, der Stromspannung der CPU von Vᵢ auf Vᵢ₊₁; oder
wenn der Hilfsprozessor bestimmt, dass die CPU bei der Spannung von Vᵢ normal arbeiten kann, Bestimmen, durch den Hilfsprozessor, dass die Mindestbetriebsspannung der CPU Vᵢ ist.

4. Verfahren nach Anspruch 1, wobei das Bestimmen einer Mindestbetriebsspannung der CPU (310) Folgendes umfasst:
Bestimmen, durch den Hilfsprozessor (320), einer Betriebsspannungsdomäne (V₀, V₁) der CPU, wobei die CPU bei der Spannung von *V*₀ nicht normal arbeiten kann und bei der Spannung von V₁ normal arbeiten kann;
Bestimmen, durch den Hilfsprozessor, von m Spannungswerten innerhalb der Betriebsspannungsdomäne (V₀, V₁) und Durchführen von Spannungsmessungen für die CPU während m Malen;
Bestimmen, durch den Hilfsprozessor, von n Spannungswerten innerhalb der Betriebsspannungsdomäne (V₀, V₁) gemäß den m Malen der Spannungsmessung, wobei die CPU bei jedem der n Spannungswerte normal arbeiten kann und n geringer als oder gleich m ist; und
Bestimmen, durch den Hilfsprozessor, eines kleinsten Spannungswerts in den n Spannungswerten als die Mindestbetriebsspannung der CPU.

5. Verfahren nach Anspruch 2 oder 3, wobei das Verfahren ferner Folgendes umfasst:
wenn der Hilfsprozessor (320) innerhalb einer voreingestellten Zeit einen Testergebniseigenwert Tᵢ erlangt hat, der durch die CPU (310) bei der Spannung von Vᵢ bestimmt ist, und Tᵢ einen voreingestellten Wert erfüllt, Bestimmen, durch den Hilfsprozessor, dass die CPU bei der Spannung von Vᵢ normal arbeiten kann;
wenn der Hilfsprozessor Tᵢ innerhalb der voreingestellten Zeit erlangt hat und Tᵢ den voreingestellten Wert nicht erfüllt, Bestimmen, durch den Hilfsprozessor, dass die CPU bei der Spannung von Vᵢ nicht normal arbeiten kann; und
wenn der Hilfsprozessor Tᵢ nicht innerhalb der voreingestellten Zeit erlangt hat, Bestimmen, durch den Hilfsprozessor, dass die CPU bei der Spannung von Vᵢ nicht normal arbeiten kann.

6. Endgerät (300), wobei das Endgerät einen Hilfsprozessor (320) und eine zentrale Verarbeitungseinheit, CPU, (310) umfasst, wobei der Hilfsprozessor zu Folgendem konfiguriert ist: in einem Einschaltprozess des Endgeräts, nach dem Beenden der Systeminitialisierung, Bestimmen einer Mindestbetriebsspannung der CPU;
wobei der Hilfsprozessor ferner dazu konfiguriert ist, eine Stromspannung der CPU auf die Mindestbetriebsspannung einzustellen; und
wobei die CPU zu Folgendem konfiguriert ist: Beenden, an der Mindestbetriebsspannung, des Einschaltprozesses des Endgeräts und Steuern des Endgeräts dazu, zu arbeiten.

7. Endgerät (300) nach Anspruch 6, wobei der Hilfsprozessor (320) insbesondere zu Folgendem konfiguriert ist:
Bestimmen einer anfänglichen Arbeitsspannung V₀, bei welcher die CPU (310) normal arbeiten kann;
Verringern der Stromspannung der CPU von Vᵢ₋₁ auf Vᵢ, wobei der Wert von i aufeinanderfolgend 1, 2, 3, ... ist; und
wenn bestimmt ist, dass die CPU bei der Spannung von Vᵢ normal arbeiten kann, Verringern der Stromspannung der CPU von Vᵢ auf Vᵢ₊₁; oder
wenn bestimmt ist, dass die CPU bei der Spannung von Vᵢ nicht normal arbeiten kann, Bestimmen, dass die Mindestbetriebsspannung der CPU Vᵢ₋₁ ist.

8. Endgerät (300) nach Anspruch 6, wobei der Hilfsprozessor (320) konkret zu Folgendem konfiguriert ist:
Bestimmen einer anfänglichen Arbeitsspannung V₀, bei der die CPU (310) nicht normal arbeiten kann;
Erhöhen der Stromspannung der CPU von Vᵢ₋₁ auf Vᵢ, wobei ein Wert von i aufeinanderfolgend 1, 2, 3, ... ist; und
wenn bestimmt ist, dass die CPU bei der Spannung von Vᵢ normal arbeiten kann, Erhöhen der Stromspannung der CPU von Vᵢ auf Vᵢ₊₁; oder
wenn bestimmt ist, dass die CPU bei der Spannung von Vᵢ normal arbeiten kann, Bestimmen, dass die Mindestbetriebsspannung der CPU Vᵢ ist.

9. Endgerät (300) nach Anspruch 6, wobei der Hilfsprozessor (320) konkret zu Folgendem konfiguriert ist:
Bestimmen einer Betriebsspannungsdomäne (V₀, Vᵢ) der CPU (310),
wobei die CPU bei der Spannung von V₀ nicht normal arbeiten kann und bei der Spannung von V₁ normal arbeiten kann;
Bestimmen von m Spannungswerten innerhalb der Betriebsspannungsdomäne (V₀, V₁) und Durchführen von Spannungsmessungen für die CPU während m Malen;
Bestimmen von n Spannungswerten innerhalb der Betriebsspannungsdomäne (V₀, V₁) gemäß den m Malen von Spannungsmessungen, wobei die CPU bei jedem der n Spannungswerte normal arbeiten kann und n geringer als oder gleich m ist; und
Bestimmen eines kleinsten Spannungswerts in den n Spannungswerten als die Mindestbetriebsspannung der CPU.

10. Endgerät (300) nach Anspruch 7 oder 8, wobei der Hilfsprozessor (320) konkret zu Folgendem konfiguriert ist:
wenn der Hilfsprozessor innerhalb einer voreingestellten Zeit einen Testergebniseigenwert Tᵢ erlangt hat, der durch die CPU (310) bei der Spannung von Vᵢ bestimmt ist, und Tᵢ einen voreingestellten Wert erfüllt, Bestimmen, dass die CPU bei der Spannung von Vᵢ normal arbeiten kann;
wenn der Hilfsprozessor Tᵢ innerhalb der voreingestellten Zeit erlangt hat und Tᵢ den voreingestellten Wert nicht erfüllt, Bestimmen, dass die CPU bei der Spannung von Vᵢ nicht normal arbeiten kann; und
wenn der Hilfsprozessor Tᵢ nicht innerhalb der voreingestellten Zeit erlangt hat, Bestimmen, dass die CPU bei der Spannung von Vᵢ nicht normal arbeiten kann.

## Revendications

1. Procédé permettant de déterminer une tension d'un processeur d'un terminal (300), dans lequel le terminal comprend un processeur auxiliaire (320) et une unité centrale de traitement, CPU (310), et le procédé comprend :
dans un processus de mise en marche du terminal, après achèvement d'une initialisation du système, la détermination, par le processeur auxiliaire, d'une tension de fonctionnement minimale de la CPU ;
le réglage, par le processeur auxiliaire, d'une tension actuelle de la CPU à la tension de fonctionnement minimale ; et
l'achèvement, par la CPU à la tension de fonctionnement minimale, du processus de mise en marche du terminal, et la commande du terminal pour qu'il fonctionne.

2. Procédé selon la revendication 1, dans lequel la détermination d'une tension de fonctionnement minimale de la CPU (310) comprend :
la détermination, par le processeur auxiliaire (320), d'une tension de fonctionnement initiale *V*₀ à laquelle la CPU peut fonctionner normalement ;
la diminution, par le processeur auxiliaire, de la tension actuelle de la CPU de *V*_{*i*-1} à *Vᵢ*, dans lequel une valeur de i est successivement 1, 2, 3, ... ; et
lorsque le processeur auxiliaire détermine que la CPU peut fonctionner normalement à la tension de *vᵢ*, la diminution, par le processeur auxiliaire, de la tension actuelle de la CPU de *Vᵢ* à *V*_{*i*+1} ; ou
lorsque le processeur auxiliaire détermine que la CPU ne peut pas fonctionner normalement à la tension de *Vᵢ*, la détermination, par le processeur auxiliaire, que la tension de fonctionnement minimale de la CPU est *V*_{*i*-1}.

3. Procédé selon la revendication 1, dans lequel la détermination d'une tension de fonctionnement minimale de la CPU (310) comprend :
la détermination, par le processeur auxiliaire (310), d'une tension de fonctionnement initiale *V*₀ à laquelle la CPU ne peut pas fonctionner normalement ;
l'augmentation, par le processeur auxiliaire, de la tension actuelle de la CPU de *V*_{*i*-1} à *Vᵢ*, dans lequel une valeur de i est successivement 1, 2, 3, ... ; et
lorsque le processeur auxiliaire détermine que la CPU ne peut pas fonctionner normalement à la tension de *Vᵢ*, l'augmentation, par le processeur auxiliaire, de la tension actuelle de la CPU de *Vᵢ* à *V*_{*i*+1} ; ou
lorsque le processeur auxiliaire détermine que la CPU peut fonctionner normalement à la tension de *vᵢ*, la détermination, par le processeur auxiliaire, que la tension de fonctionnement minimale de la CPU est *Vᵢ*.

4. Procédé selon la revendication 1, dans lequel la détermination d'une tension de fonctionnement minimale de la CPU (310) comprend :
la détermination, par le processeur auxiliaire (320), d'un domaine de tensions de fonctionnement (*V*₀, *V*₁) de la CPU, dans lequel la CPU ne peut pas fonctionner normalement à la tension de *V*₀, et peut fonctionner normalement à la tension de *V*₁;
la détermination, par le processeur auxiliaire, de m valeurs de tension dans le domaine de tensions de fonctionnement (*V*₀, *V*₁), et la réalisation d'une mesure de tension pour la CPU pendant m fois ;
la détermination, par le processeur auxiliaire, de n valeurs de tension dans le domaine de tensions de fonctionnement (*V*₀, *V*₁) selon les m temps de mesure de tension, dans lequel la CPU peut fonctionner normalement à chacune des n valeurs de tension, et n est inférieur ou égal à m ; et
la détermination, par le processeur auxiliaire, d'une valeur de tension la plus petite dans les n valeurs de tension en tant que tension de fonctionnement minimale de la CPU.

5. Procédé selon la revendication 2 ou 3, dans lequel le procédé comprend en outre :
lorsque le processeur auxiliaire (320) a obtenu, dans un temps prédéfini, une valeur propre de résultat d'essai *Tᵢ* qui est déterminée par la CPU (310) à la tension de *Vᵢ*, et *Tᵢ* satisfait une valeur prédéfinie, la détermination, par le processeur auxiliaire, que la CPU peut fonctionner normalement à la tension de *Vᵢ ;*
lorsque le processeur auxiliaire a obtenu *Tᵢ* dans le temps prédéfini, et *Tᵢ* ne satisfait pas la valeur prédéfinie, la détermination, par le processeur auxiliaire, que la CPU ne peut pas fonctionner normalement à la tension de *Vᵢ* ; et
lorsque le processeur auxiliaire n'a pas obtenu *Tᵢ* dans le temps prédéfini, la détermination, par le processeur auxiliaire, que la CPU ne peut pas fonctionner normalement à la tension de *Vᵢ*.

6. Terminal (300), le terminal comprenant un processeur auxiliaire (320) et une unité centrale de traitement, CPU (310), dans lequel le processeur auxiliaire est conçu pour : dans un processus de mise en marche du terminal, après achèvement d'une initialisation du système, déterminer une tension de fonctionnement minimale de la CPU ;
le processeur auxiliaire est en outre conçu pour régler une tension actuelle de la CPU à la tension de fonctionnement minimale ; et
la CPU est conçue pour : achever, à la tension de fonctionnement minimale, le processus de mise en marche du terminal, et commander le terminal pour qu'il fonctionne.

7. Terminal (300) selon la revendication 6, dans lequel le processeur auxiliaire (320) est conçu spécifiquement pour :
déterminer une tension de fonctionnement initiale *V*₀ à laquelle la CPU (310) peut fonctionner normalement ;
diminuer la tension actuelle de la CPU de *V*_{*i*-1} à *Vᵢ*, dans lequel une valeur de i est successivement 1, 2, 3, ... ; et
lors de la détermination que la CPU peut fonctionner normalement à la tension de *Vᵢ*, diminuer la tension actuelle de la CPU de *Vᵢ* à *V*_{*i*+1} ; ou
lors de la détermination que la CPU ne peut pas fonctionner normalement à la tension de *Vᵢ*, déterminer que la tension de fonctionnement minimale de la CPU est *V*_{*i*-1}.

8. Terminal (300) selon la revendication 6, dans lequel le processeur auxiliaire (320) est conçu spécifiquement pour :
déterminer une tension de fonctionnement initiale *V*₀ à laquelle la CPU (310) ne peut pas fonctionner normalement ;
augmenter la tension actuelle de la CPU de *V*_{*i*-1} à *Vᵢ*, dans lequel une valeur de i est successivement 1, 2, 3, ... ; et
lors de la détermination que la CPU peut fonctionner normalement à la tension de *Vᵢ*, augmenter la tension actuelle de la CPU de *Vᵢ* à *V*_{*i*+1} ; ou
lors de la détermination que la CPU peut fonctionner normalement à la tension de *Vᵢ*, déterminer que la tension de fonctionnement minimale de la CPU est *Vᵢ*.

9. Terminal (300) selon la revendication 6, dans lequel le processeur auxiliaire (320) est conçu spécifiquement pour :
déterminer un domaine de tensions de fonctionnement (*V*₀, *V*₁) de la CPU (310), dans lequel la CPU ne peut pas fonctionner normalement à la tension de *V*₀, et peut fonctionner normalement à la tension de *V*₁;
déterminer m valeurs de tension dans le domaine de tensions de fonctionnement (*V*₀, *V*₁), et réaliser une mesure de tension pour la CPU pendant m fois ;
déterminer n valeurs de tension dans le domaine de tensions de fonctionnement (*V*₀, *V*₁) selon les m temps de mesure de tension,
dans lequel la CPU peut fonctionner normalement à chacune des n valeurs de tension, et n est inférieur ou égal à m ; et
déterminer une valeur de tension la plus petite dans les n valeurs de tension en tant que tension de fonctionnement minimale de la CPU.

10. Terminal (300) selon la revendication 7 ou 8, dans lequel le processeur auxiliaire (320) est conçu spécifiquement pour :
lorsque le processeur auxiliaire a obtenu, dans un temps prédéfini, une valeur propre de résultat d'essai *Tᵢ* qui est déterminée par la CPU (310) à la tension de *Vᵢ*, et *Tᵢ* satisfait une valeur prédéfinie, déterminer que la CPU peut fonctionner normalement à la tension de *Vᵢ* ;
lorsque le processeur auxiliaire a obtenu *Tᵢ* dans le temps prédéfini, et *Tᵢ* ne satisfait pas la valeur prédéfinie,
déterminer que la CPU ne peut pas fonctionner normalement à la tension de *Vᵢ* ; et
lorsque le processeur auxiliaire n'a pas obtenu *Tᵢ* dans le temps prédéfini, déterminer que la CPU ne peut pas fonctionner normalement à la tension de *Vᵢ*.
